Europäisches Patentamt

European Patent Office

Office européen des brevets

(19)

(11) Numéro de publication: **0 205 373
B1**

(12) **FASCICULE DE BREVET EUROPEEN**

(45) Date de publication du fascicule du brevet:
20.12.89

(51) Int. Cl.⁴: **H03H 17/08, H04N 5/95**

(21) Numéro de dépôt: 86401093.9

(22) Date de dépôt: 23.05.86

(54) **Déphaseur variable numérique et correcteur de vélocité numérique pour magnétoscope utilisant un tel déphaseur.**

(30) Priorité: 24.05.85 FR 8507902

(43) Date de publication de la demande:
17.12.86 Bulletin 86/51

(45) Mention de la délivrance du brevet:
20.12.89 Bulletin 89/51

(84) Etats contractants désignés:
DE GB

(56) Documents cités:
DE-A- 2 943 174
FR-A- 2 276 748

ELEKTRONIK,
vol. 33, no. 1, janvier 1984, pages 57-64, Munich, DE: Ch.
TIEFENTHALER: "Digitale Transversalfilter"
ELEKTRONIK,
vol. 31, no. 21, octobre 1982, pages 121-124, Munich, DE;
P. DRAHEIM: "Digitalisierung der
Video-Signalverarbeitung Beispiel:
Video-Kassettenrecorder"
FERNSEH- & KINOTECHNIK,
vol. 38, no. 5, mai 1984, pages 187-194, Berlin, DE; J.
HEITMANN et al.: "Digitale Videoaufzeichnung
Grundlagen - Standardisierung - Entwicklungen"

(73) Titulaire: **THOMSON VIDEO EQUIPEMENT, 94, rue du
Fossé Blanc, F-92320 Gennevilliers(FR)**

(72) Inventeur: **Porrot, Pascal, THOMSON-CSF
SCPI 19, avenue de Messine, F-75008 Paris(FR)**

(74) Mandataire: **Lincot, Georges et al, THOMSON-CSF SCPI,
F-92045 PARIS LA DEFENSE CEDEX 67(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

**Description**

La présente invention concerne un déphaseur variable numérique et plus particulièrement un correcteur de vélocité numérique pour magnétoscope utilisant un tel déphaseur. Dans les magnétoscopes le correcteur de vélocité a pour fonction de corriger l'erreur de phase produite entre la référence temporelle du signal vidéo enregistré et la référence temporelle du signal vidéo correspondant qui a été fourni par les équipements de prise de vues. Les correcteurs de vélocité connus mettent en oeuvre soit des solutions purement analogiques où les retards de phase sont compensés par des lignes à retard soit des dispositifs hybrides à la fois numériques et analogiques disposant d'une horloge d'échantillonnage modulée en phase en fonction de l'erreur de phase produite entre les références temporelles du signal vidéo enregistré et le signal vidéo correspondant qui a été fourni par les équipements de prise de vues.

Dans l'un ou l'autre cas, les lignes à retard utilisées et les oscillateurs commandés en tension qui permettent de moduler en phase le signal d'échantillonnage nécessitent des réglages qui augmentent de façon non négligeable le prix de revient des magnétoscopes incorporant les correcteurs de vélocité précités.

Des solutions à ces inconvénients peuvent sans conteste être trouvées en mettant en oeuvre des dispositifs de correction de phase entièrement numériques, mais ces solutions sont encore onéreuses à cause principalement du nombre important d'opérateurs numériques qui est exigé pour leur réalisation.

Le but de l'invention est de pallier les inconvénients précités.

A cet effet, l'invention a pour objet, un déphaseur variable numérique caractérisé en ce qu'il comprend un correcteur de phase à temps de propagation variable constitué par un filtre numérique transversal non récursif, ayant un nombre N déterminé pair de coefficients, couplé à un correcteur d'amplitude pour corriger les variations de gain du correcteur de phase de manière à obtenir un gain global du déphaseur variable numérique à peu près constant.

L'invention a également pour objet, un correcteur de vélocité de magnétoscope numérique pour corriger l'erreur de phase existant entre la référence temporelle d'un signal vidéo enregistré et la référence temporelle du signal vidéo fourni par l'équipement de prise de vues caractérisé en ce qu'il incorpore le déphaseur variable numérique précité.

D'autres caractéristiques et avantages de l'invention apparaîtront au cours de la description faite au regard des dessins annexés donnés uniquement à titre d'exemple qui représentent :

- la figure 1 un diagramme des temps qui illustre le principe de correction d'erreur de phase mis en oeuvre dans le correcteur de vélocité selon l'invention ;
- la figure 2 un schéma illustrant le principe mis en oeuvre pour réaliser un correcteur de vélocité selon l'invention ;
- la figure 3 la réponse amplitude/fréquence d'un filtre passe-bas parfait ;
- la figure 4 la réponse impulsionnelle d'un filtre passe-bas parfait ;
- la figure 5 le mode d'échantillonnage de la réponse impulsionnelle d'un filtre passe-bas parfait pour obtenir un filtre numérique passe-bas à phase linéaire ;
- la figure 6 une réalisation d'un filtre passe-bas numérique à phase linéaire ;
- la figure 7 un exemple de réalisation d'un filtre numérique d'ordre impair ;
- la figure 8 une méthode de détermination du module de la fonction de transfert du filtre de la figure 7 par la représentation vectorielle ;
- la figure 9 la répartition des coefficients k(i) d'un filtre d'ordre pair ;
- la figure 10 une méthode de détermination de la fonction de transfert d'un filtre d'ordre pair par la représentation vectorielle ;
- la figure 11 un schéma équivalent d'un filtre à temps de propagation variable ;
- la figure 12 la réponse impulsionnelle d'un filtre passe-bas idéal d'ordre impair ;
- la figure 13 la réponse impulsionnelle d'un filtre passe-bas idéal échantillonné avec un retard d'une demi-période d'échantillonnage;
- les figures 14A, 14B, 14C, et 14D les réponses impulsionnelles et la variation du module M(ω) d'un correcteur de phase à quatre coefficients ;
- les figures 15 et 16 des représentations vectorielles du module M(ω) et de la phase Φ(ω,α) obtenues en fonction des coefficients k(i) appliqués sur le filtre à quatre coefficients représenté à la figure 14A ;
- la figure 17 la réponse impulsionnelle du filtre de la figure 14A ;
- la figure 18 la courbe d'amplitude du module M(ω) de la fonction de transfert du filtre de la figure 14A en fonction de la fréquence ;
- la figure 19 la représentation graphique de l'erreur du temps de propagation du filtre par rapport à la consigne de phase souhaitée ;
- la figure 20 le principe de correction d'amplitude adopté pour corriger les variations de gain du correcteur de vélocité ;
- la figure 21 un schéma synoptique de réalisation du correcteur de vélocité de l'invention ;
- la figure 22 un filtre numérique basse bande à cinq coefficients ;

- la figure 23 la courbe du module de la fonction de transfert du filtre obtenu après la correction d'amplitude appliquée en sortie du correcteur de phase de la figure 21 ;
- la figure 24 l'architecture du correcteur de vélocité selon l'invention ;
- la figure 25 un diagramme d'état expliquant l'aiguillage des signaux vidéo à l'entrée du correcteur de phase .
- la figure 26 un tableau représentant la réponse impulsionnelle du filtre correcteur de vélocité qui correspond à un filtre à huit coefficients.

Le déphaseur variable numérique appliqué au correcteur de vélocité selon l'invention a pour rôle de corriger les erreurs qui se produisent au cours de la durée de balayage d'une ligne d'image déterminée par les signaux de synchronisation du signal vidéo. Cette correction garantit la remise en phase des signaux de chrominance portés par le signal vidéo mais ne garantit pas la mise en phase du signal vidéo enregistré sur la phase ligne de l'équipement qui a permis l'enregistrement.

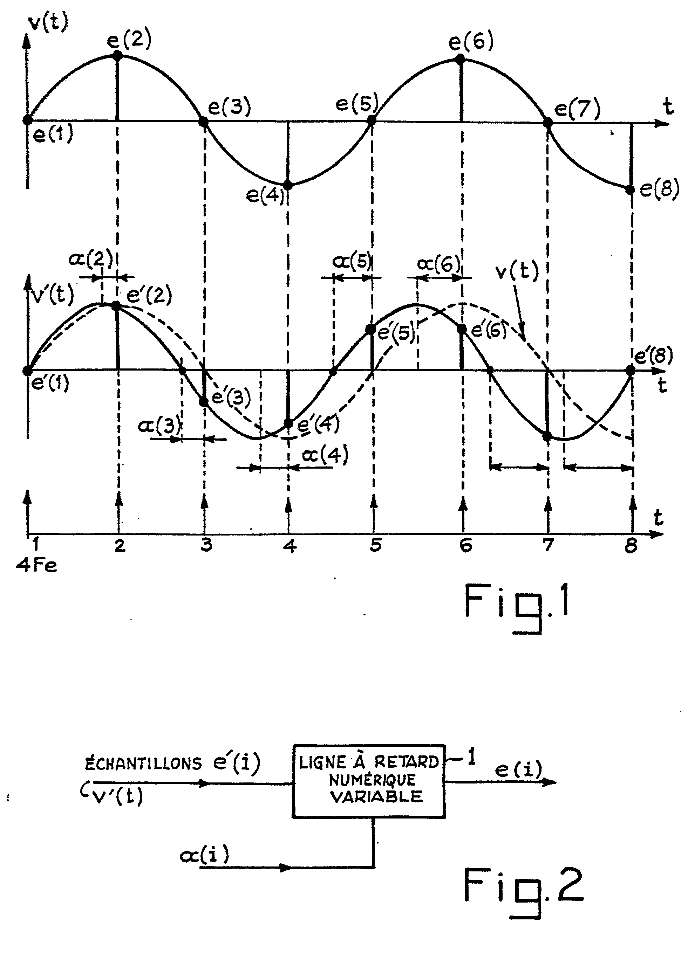

Autrement dit, le signal vidéo enregistré qui varie dans le temps de façon élastique est transformé par le correcteur de vélocité en un signal stable dans l'intervalle de temps ligne du signal vidéo. Le principe de la correction adopté est décrit ci-après en se reportant au diagramme des temps de la figure 1 en prenant comme exemple pour simplifier, une restitution par les têtes de lecture d'un magnétoscope d'un signal V'(t) sinusoïdal comparativement au signal V(t) correspondant qui a été fourni par l'équipement de prise de vues. Des échantillons de ces signaux e(i) et e'(i) sont également représentés sur la figure 1 espacés par des intervalles de

$$\frac{1}{4Fe},$$

Fe désignant la fréquence du signal de référence de phase sous porteuse couleur issu des équipements de prise de vues. Comparé au signal V(t) le signal V'(t) apparaît comme entaché d'une erreur de base de temps. Les échantillons e(i) et e'(i) qui ont une distribution spatiale constante du fait que la fréquence d'échantillonnage 4Fe, représentent les signaux V(t) et V'(t) avec une erreur de base de temps instantanée $\alpha(i)$ . Pour corriger le signal V'(t) de cette erreur il faut calculer aux instants t(i) les échantillons e(i) à partir d'échantillons e'(i) et de l'erreur de phase $\alpha(i)$ . Ce calcul est réalisé, selon l'invention, à l'aide d'un filtre "passe-tout" numérique particulier, représenté schématiquement avec la référence 1 sur la figure 2, qui reçoit le signal échantillonné V'(t) et la consigne de phase instantanée $\alpha(i)$ . Ce filtre délivre la suite des échantillons e(i) du signal corrigé correspondant à V(t) . Comme la distribution spatiale des échantillons est constante, le filtre "passe-tout" numérique permet en modifiant l'amplitude des échantillons de changer la phase de ceux-ci.

Cependant, dans l'application présente, le filtre "passe-tout" doit avoir un temps de propagation $\tau(i)$ constant pour une consigne de phase $\alpha(i)$ donnée. Cette condition est nécessaire pour obtenir une phase linéaire $\phi(i) = \omega . \tau(i)$ dans tout le domaine des fréquences vidéo compris par exemple entre 0 et 5,5 MHz car une phase non linéaire, ferait apparaître une distorsion de phase différentielle qui serait nuisible à une bonne restitution des couleurs. Le filtre "passe-tout" est donc équivalent dans ces conditions à une ligne à retard variable.

La consigne de phase instantanée $\alpha(i)$ qui correspond à l'erreur de phase fine qui est l'erreur de vélocité du signal vidéo lu sur la bande du magnétoscope est calculée sur une plage d'une période de sousporteuse couleur des standards de télévision connus sous les désignations PAL ou NTSC dans lesquels la phase est représentative de la couleur. L'équivalent relatif est mesuré dans le standard de télévision connu sous la désignation SECAM sur l'impulsion de synchronisation horizontale. Dans ces conditions l'erreur de phase peut être exprimée sur une plage angulaire de $2\pi$ radians et les erreurs entières de

$$n.\frac{\pi}{2}$$

radians sont corrigées par translation du signal vidéo échantillonné de n fois la période d'échantillonnage en choisissant cette dernière égale à 4 fois la fréquence de la sous-porteuse couleur. Ceci permet, après avoir corrigé le signal du nombre entier de pas d'horloge d'échantillonnage compris dans la mesure $\alpha(i)$ , de corriger l'erreur à l'intérieur d'un pas d'échantillonnage $(0,\pi/2)$, ce pas ayant une durée de 56 ns dans les standards 625 lignes et de 70 ns dans les standards 525 lignes. A titre d'exemple, la mesure de l'erreur de phase fine pourra être exprimée en numérique par un mot d'une longueur de 9 bits correspondant à 512 niveaux pour une plage de $2\pi$ radians soit encore de 128 pas pour une plage de $\pi/2$ radians. Le pas élémentaire sera alors de 90° divisé par 128 soit 0,7° ou encore 0,44 ns pour le standard PAL. Naturellement, quelque soit le type de réalisation adopté, le correcteur de vélocité doit avoir une erreur propre négligeable par rapport à la mesure de l'erreur fine de façon à conserver la précision de cette dernière.

Le filtre passe-bas selon l'invention possède une réponse impulsionnelle se rapprochant le plus possible de la réponse impulsionnelle d'un filtre passe-bas parfait caractérisé par une réponse amplitu-

de/fréquence $S(\omega)$ rectangulaire avec une fréquence de coupure

$$fo = \frac{\omega o}{2\pi}$$

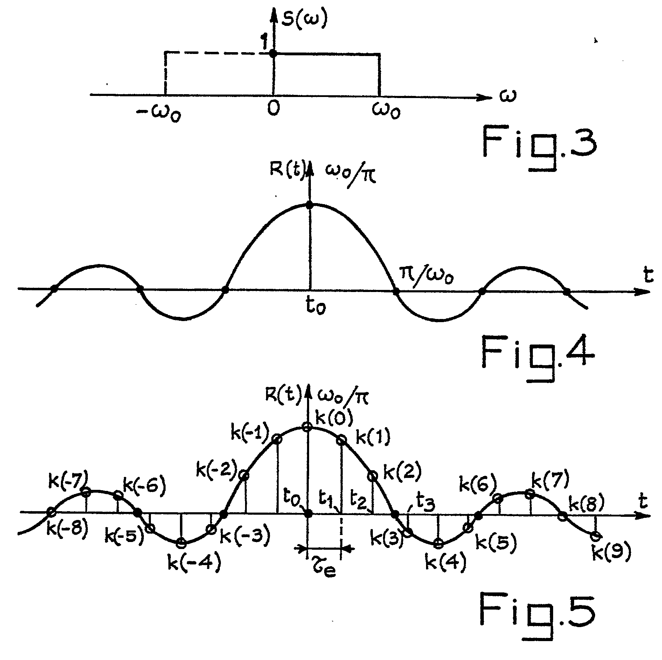

telle que schématisée à la figure 3, (fo étant égale une demi-fois la fréquence d'échantillonnage soit deux fois la fréquence de référence) et par une réponse temporelle R(t) représentée à la figure 4 qui vérifie la relation

$$R(t) = \frac{\omega o}{\pi} \cdot \frac{\sin \omega ot}{\omega ot} \qquad (1)$$

Le graphe correspondant est représenté à la figure 4, il résulte du calcul de la transformée de Fourier inverse de la réponse $S(\omega)$ défini par la relation

$$R(t) = \frac{1}{2\pi} \int_{-\omega o}^{+\omega o} S(\omega).e^{j\omega t} \cdot d\omega. \qquad (2)$$

La réponse impulsionnelle du filtre numérique équivalent est représentée à la figure 5.

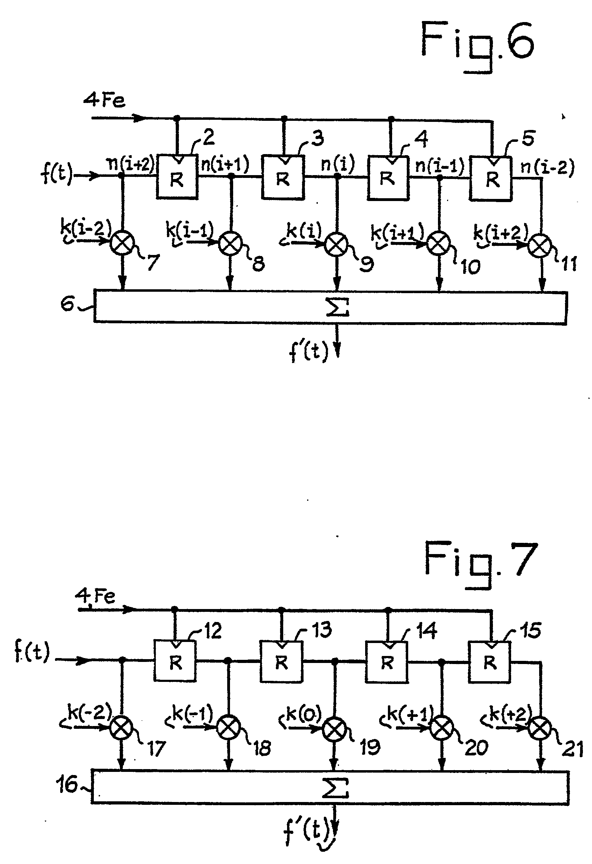

Un modèle de réalisation d'un tel filtre est représenté à la figure 6. Le filtre de la figure 6 a une structure de filtre transversal, non récursif, et est formé par l'ensemble de registres 2 à 5 reliés en série et fonctionnant à une fréquence 4Fe, les sorties respectives des registres 2 à 5 étant reliées à un circuit sommateur 6 au travers de circuits multiplicateurs numérotés respectivement de 7 à 11.

La décomposition temporelle en instants t(i) du signal à filtrer est obtenue dans ces conditions à l'aide des registres 2 à 5 reliés en série qui transmettent les échantillons n(i) au rythme de la fréquence d'échantillonnage 4Fe définie précédemment, et le filtre numérique qui a les caractéristiques précitées est obtenu en effectuant dans le sommateur 6 la somme des échantillons n(i) pris aux instants t(i) multipliés par les coefficients multiplicateurs k(i) appliqués sur les entrées des circuits multiplicateurs 7 à 11. Les amplitudes des échantillons de la réponse échantillonnée à la fréquence 4Fe représentée à la figure 5 donne les coefficients multiplicateurs k(i) du signal filtré pris aux instants t(i).

Naturellement, les considérations précédentes supposent que les conditions du théorème de Shanon sont respectées, et que le nombre de coefficients k(i) n'est pas limité. En fait, la réponse impulsionnelle du filtre représenté à la figure 5 est tronquée puisque le nombre de coefficients utilisés est fini, et sa réponse spectrale $S(\omega)$ ne correspond pas exactement à celle du filtre passe-bas idéal précédemment définie.

D'autre part, comme l'intervalle entre deux échantillons vidéo n(i) , n(i+1) est constant et égal à la période d'échantillonnage

$$\tau(e) = \frac{1}{4Fe}$$

la phase de l'échantillon d'ordre n(i+1) par rapport à celle de l'échantillon d'ordre n(i) est égale à $\phi n(i+1) = \omega.\tau e$.

De façon plus générale, un filtre d'ordre impair, c'est-à-dire un filtre dont le nombre de coefficients N est impair, aura un retard constant égal à

$$\frac{N-1}{2} \cdot \tau e,$$

ce retard correspondant à un nombre entier de périodes d'échantillonnage $\tau e$ et un filtre d'ordre pair, aura un retard aussi constant égal à

$$(\frac{N-1}{2}) \cdot \tau e$$

égal à un nombre entier de demi-période $\tau e$.

Il résulte de ceci que par le choix de l'ordre il est possible d'effectuer un décalage de phase entre $p.\tau e$ et

$$p . \tau e \pm \frac{\tau e}{2}$$

avec p entier.

Dans les cas par exemple, où les filtres utilisés sont d'ordre N = 5 et d'ordre N = 4 et pour le domaine où la réponse amplitude/fréquence $T(\omega)$ est égale à 1 le signal vidéo numérique f'(t) obtenu en sortie des filtres correspondant en fonction du signal vidéo f(t) numérique appliqué à l'entrée du filtre a pour expression

pour N = 5 → f'(t) = f(t-2τe)

et pour N = 4 → f'(t) = f(t-1,5τe)

La détermination du module des filtres non récursif selon l'invention par la représentation vectorielle est la suivante. L'origine des phases est déterminée par le point correspondant au retard du filtre

$$\frac{N-1}{2} . \tau e$$

soit

$$\varphi o = - \omega . (\frac{N-1}{2}) . \tau e$$

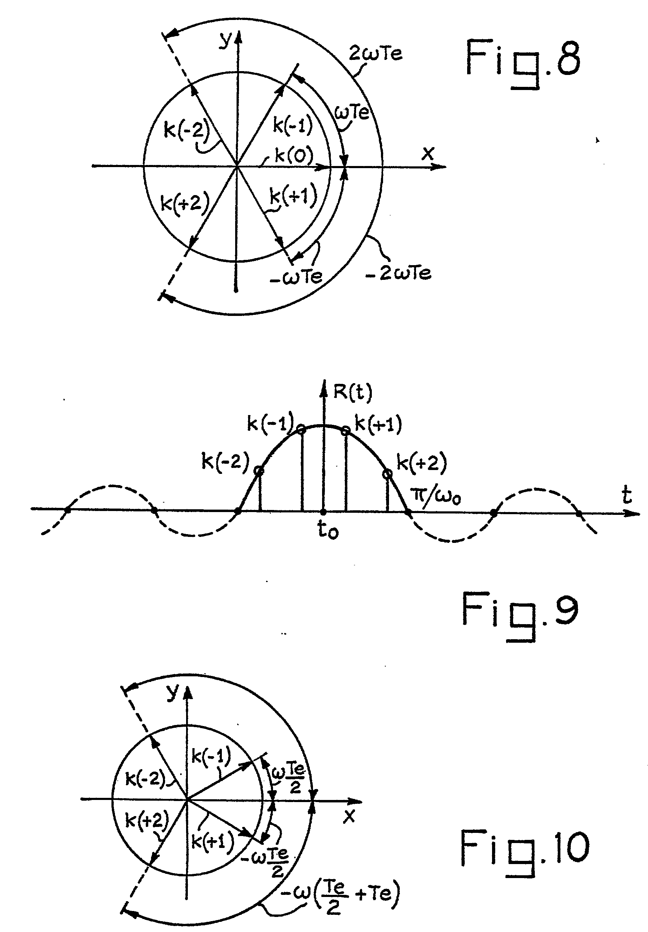

La représentation vectorielle correspondante pour un filtre transversal non récursif d'ordre N = 5, du type de celui qui est représenté par les éléments 12 à 21 de la figure 7, est décrite ci-après à l'aide de la figure 8.

Selon cette représentation, la somme des projections sur l'axe Y de la figure est nulle et par conséquent la phase est égale à 0 ou à $\pi$ par rapport à l'origine des phases $\varphi o$. Dans ce cas, le module de la fonction de transfert $T(\omega)$ du filtre est donné par la valeur absolue de la somme des projections sur l'axe X.

La symétrie de la réponse impulsionnelle donne une symétrie entre les vecteurs k(i) et k(-i) par rapport à l'axe X.

Pour un filtre d'ordre impair avec N coefficients, le module $M(\omega)$ sera donné par la relation
$M(\omega)= ko+2k(1)x \cos(\omega\tau e)+2k(2)x \cos(2\omega\tau e)+...+ 2k(N-1)x \cos$

$$(\frac{N-1}{2}) \omega\tau e \quad (4)$$

Pour un filtre d'ordre pair, par exemple N = 4, l'origine des phases est déterminée par

$$\varphi o = - \omega \frac{N-1}{2} \tau e$$

soit

$\phi o = - \omega. 1,5 \tau e$

et les coefficients k(i) sont répartis comme représenté à la figure 9 symétriquement par rapport à l'origine to de la réponse impulsionnelle R(t). Il n'y a pas de coefficient central k(o). Le module $M(\omega)$ est donné par la valeur absolue de la somme des vecteurs k(i) projetés sur l'axe X suivant la représentation vectorielle de la figure 10. Toujours suivant cette représentation la somme des projections sur l'axe Y de la figure 10 est nulle. La phase du vecteur résultant est nulle ou est égale à $\pi$ , par rapport à l'origine de phase

$$\varphi o = - \omega . \frac{N-1}{2} . \tau e.$$

Pour un filtre d'ordre pair le module $M(\omega)$ est donné par la relation générale
$M(\omega)=2k(1)x \cos(0,5\omega\tau e)+2k(2)x \cos(1,5 \omega\tau e)+...+2k(N/2)x \cos$

$$\left( \frac{N-1}{2} \omega \tau e \right) \quad (5)$$

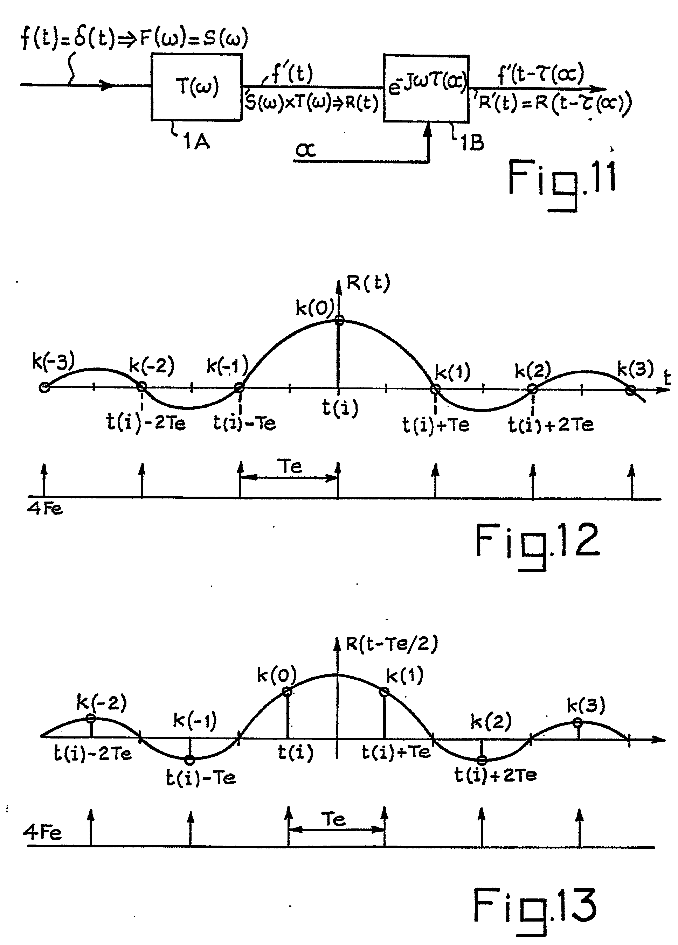

La réalisation d'un filtre selon l'invention à temps de propagation variable s'obtient à partir de la réponse impulsionnelle idéale d'un filtre passe-bas à une impulsion $\delta(t)$. La figure 11 schématise sa réalisation.

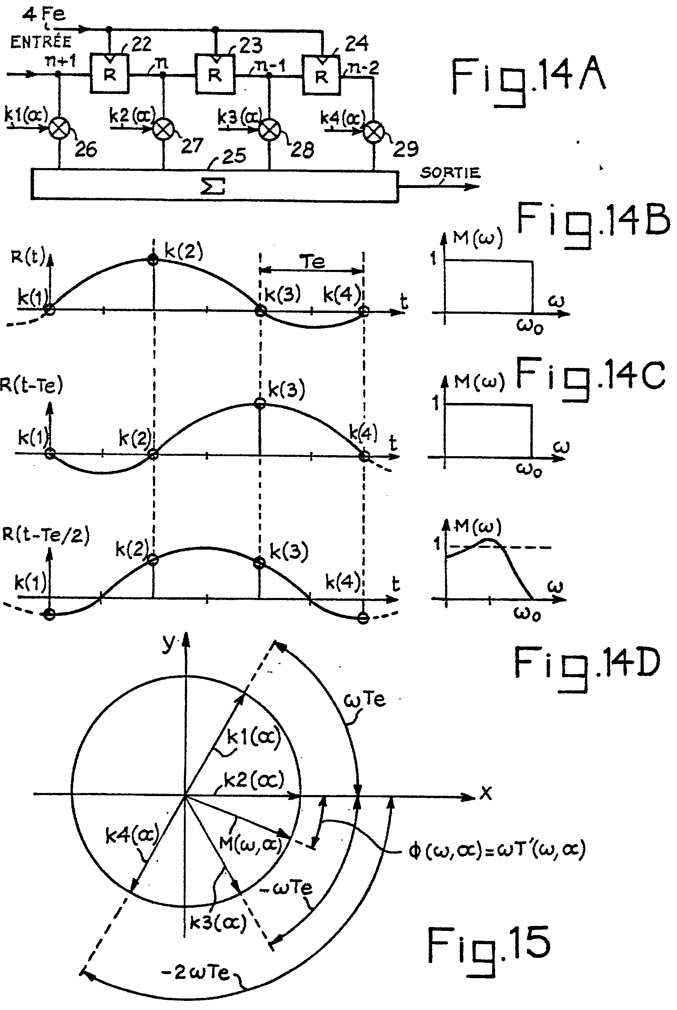

La réponse impulsionnelle R'(t) en sortie du filtre représenté à la figure 11 est égale à la réponse impulsionnelle R(t) retardée de $\tau(\alpha)$ avec $\tau(\alpha) = \alpha /\omega e$ , $\omega e$ étant la pulsation de la référence de phase des signaux burst de couleur. Ce principe est valable dans la mesure où le module $M(\omega)$ de la fonction de transfert $T(\omega)$ du filtre passe-bas est égale à 1 dans la bande passante utile. Un filtre passe-bas idéal d'ordre impair dont la fréquence de coupure fo correspond à la demi-fréquence d'échantillonnage 2Fe, donne la réponse impulsionnelle échantillonnée de la figure 12 où il apparaît que tous les coefficients k(i) pour i différent de 0 sont nuls. Seul le coefficient k(o) est égal à 1 et le retard du filtre est constant et égal à t(i) . Le même filtre qui a pour retard constant t(i) + Te avec

$$Te = \frac{\pi}{2 \omega e}$$

possède tous ces coefficients nuls sauf le coefficient k1 qui prend dans ce cas la valeur 1. Egalement le même filtre est obtenu avec un retard constant

$$ti = \frac{Te}{2}$$

en réalisant la réponse impulsionnelle R(t) par les coefficients k(i) de la figure 13.

En généralisant, un filtre passe-bas de retard quelconque $\tau(\alpha)$ par rapport à la référence de retard t(i) est obtenu en translatant la réponse impulsionnelle R(t) de $\tau(\alpha)$ et en échantillonnant cette dernière pour obtenir la valeur des coefficients k(i) . Cette méthode est celle utilisée pour réaliser le correcteur de vélocité chargé de corriger l'erreur fine de base de temps du signal vidéo.

En pratique le nombre de coefficients k(i) est limité et il s'ensuit une variation de la réponse amplitude/fréquence en fonction du retard demandé $\tau(\alpha)$. Cette variation d'amplitude entraine du bruit particulièrement gênant dans le spectre basse fréquence et dans le spectre de chrominance autour de la sous-porteuse couleur. Les coefficients k(i) sont par conséquent calculés pour que ces deux points du spectre des fréquences ne varient pas en amplitude et en phase.

Une réalisation conforme à ce principe est décrite ci-après à l'aide des figures 14A à 14D qui représentent, la figure 14A la structure du correcteur de phase sous la forme d'un filtre transversal non récursif à quatre coefficients k1($\alpha$) à k4($\alpha$) formé de trois registres 22, 23 et 24, d'un sommateur 25 et de quatre multiplieurs 26 à 29 et les figures 14B à 14D les réponses impulsionnelles et les variations du module $M(\omega)$ de la fonction de transfert du filtre pour des valeurs de déphasage $\alpha$ ayant respectivement pour valeur 0,

$$\frac{\pi}{2} \text{ et } \frac{\pi}{4}.$$

Dans ces conditions, le retard du filtre

$$\tau(\alpha) = \frac{\alpha}{\omega e}$$

varie de 0 à Te pour $\alpha$ variant de 0 à

$$\frac{\pi}{2}.$$

Les pas entiers de n fois

$$\frac{\pi}{2}$$

de l'erreur de phase sont corrigés par translation de nTe de l'échelle de retard de base constituée par les registres 22 à 24. En conservant une réponse impulsionelle R(t) de la forme

$$\frac{sinus\ 2\alpha}{2\ \alpha}\ ,$$

le module n'est pas constant et passe par un maximum de variation pour

$$\alpha = \frac{\pi}{4}$$

comme ceci est représenté à la figure 14D soit pour

$$\tau = \frac{Te}{2}\ ,$$

l'origine des phases étant fixée par le coefficient k2 .

La détermination des coefficients k(i)($\alpha$) est réalisée pour qu'en sortie du correcteur deux points du spectre des fréquences aient un module $M(\omega,\alpha)$ constant égal à 1 et une phase $\phi(\omega,\alpha)$ égale à

$$- \omega\tau\ (\alpha) = \frac{\alpha}{\omega\ e}$$

quelque soit la consigne de retard

$$\tau(\alpha) = \frac{\alpha}{\omega\ e}.$$

Ces deux points sont $\omega = 0$ et $\omega = \omega$

$$e = \frac{\pi}{2Te}\ .$$

Ces conditions sont nécessaires pour éviter le bruit basse fréquence à structure lignée et le bruit de phase et d'amplitude de la couleur dans le spectre de chrominance.

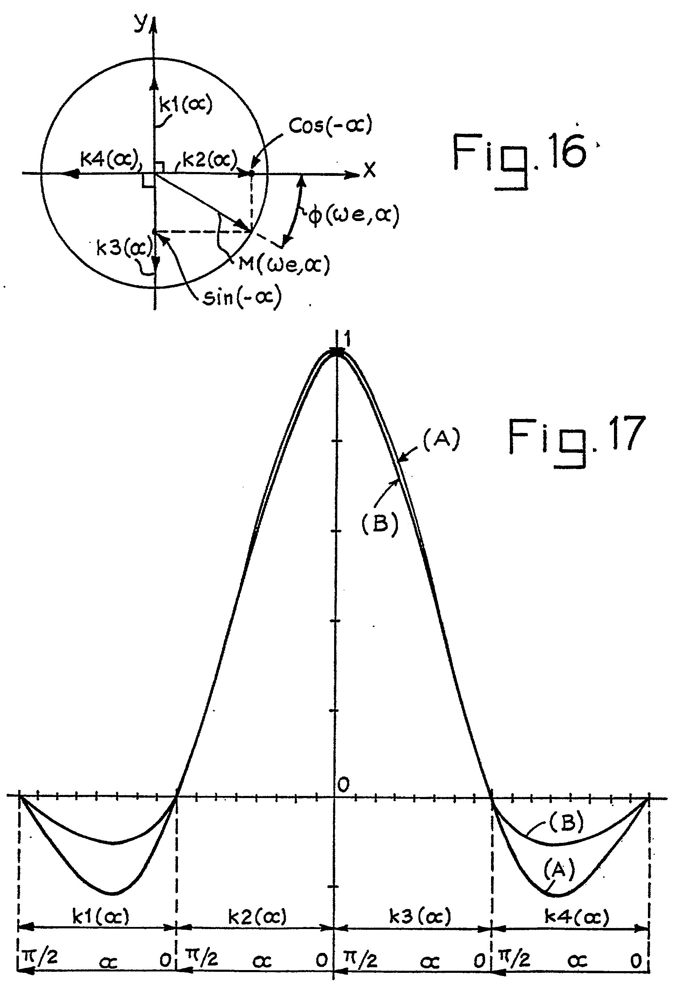

Les représentations vectorielles correspondantes des figures 15 et 16 permettent de déterminer à partir des coefficients k(i) le module $M(\omega,\alpha)$ et la phase $\phi(\omega,\alpha)$.

Sur la figure 15, la somme des projections sur l'axe X des vecteurs k(i)($\alpha$) donne $X(\omega,\alpha)$ suivant la relation
$X(\omega,\alpha)=k1(\alpha)\cos(\omega Te)+k2(\alpha)+k3(\alpha)\cos(-\omega Te)+k4(\alpha)\cos(-2\ \omega Te)$ ... (6)

La somme des projections sur l'axe Y des vecteurs k(i)($\alpha$) donne $\phi(\omega,\alpha)$ suivant la relation
$\phi(\omega,\alpha)=k_1(\alpha)\sin(\omega Te)+k3(\alpha)\sin(-\omega Te)+k4(\alpha)\sin(-2\ \omega Te)$ ... (7)

Des formules (6) et (7) le module $M(\omega,\alpha)$ et la phase $\phi(\omega,\alpha)$ peuvent être déduits par les relations :

$$M(\omega,\alpha) = \sqrt{X^2(\omega,\alpha) + Y^2(\omega,\alpha)} \qquad (8)$$

et $\phi(\omega,\alpha) = Arc\ tg\ (Y(\omega,\alpha)/X(\omega,\alpha))$ ... (9)

On en déduit également le retard $\tau'(\omega,\alpha)$ par la relation

$$\tau'(\omega,\alpha) = - \frac{1}{\omega}\ \phi\ (\omega,\alpha) \qquad (10)$$

qui est à comparer au retard théorique souhaité

$$\tau\ (\alpha) = \frac{\alpha}{\omega\ e}$$

Au point $\omega = \omega e$ , la représentation vectorielle est celle de la figure 16. A partir de la figure 16, les relations suivantes peuvent être écrites.

7

$k2(\alpha) - k4(\alpha) = \cos(-\alpha) \ ... \ (11)$

$k1(\alpha) - k3(\alpha) = \sin(-\alpha) \ ... \ (12)$

Les équations (11) et (12) vérifient aussi la condition imposée sur le module $M(\omega e, \alpha)$ soit

$$M(\omega e, \alpha) = \sqrt{\cos^2\alpha + \sin^2\alpha} = 1 \qquad (13)$$

Pour $\omega = 0$, une troisième équation est obtenue par la condition que le module doit être $M(0,\alpha)$ doit être à 1 c'est-à-dire

$k1(\alpha) + k2(\alpha) + k3(\alpha) + k4(\alpha) = 1 \ ... \ (14)$

Comme la phase pour $= 0$ n'est pas significative, il est possible d'écrire selon cette condition que la limite de $X(\omega \to 0, \alpha)$ quand $\omega$ tend vers 0 tend vers 1 puisque les cosinus tendent vers 1 et que la limite de $Y(\omega \to 0, \alpha)$ est égale à $\omega$ Te $.[(k1(\alpha) - k3(\alpha) - 2k4(\alpha))]$
puisque Sin $\omega$ Te tend vers $\omega$ Te lorsque tend vers 0. La connaissance de $X(\omega \to 0, \alpha)$ et $Y(\omega \to 0, \alpha)$ permet de déterminer la phase de $\phi(\omega \to 0, \alpha)$ par les relations
$\phi(\omega \to 0, \alpha) = $ arc $tg(Y(\omega \to 0, \alpha))$ avec $Y(\omega \to 0, \alpha) \to 0$ soit $\phi(\omega \to 0, \alpha) = Y(\omega \to 0, \alpha)$. Le retard du filtre devient alors
$\tau'(\omega \to 0, \alpha) = $

$$-\frac{1}{\omega}$$

$Y(\omega \to 0, \alpha) = $ Te $(-K1(\alpha) + K3(\alpha) + 2K4(\alpha))$
Ce retard $\tau'(\omega \to 0, \alpha)$ doit être égal au retard souhaité soit

$$\tau(\alpha) = \frac{\alpha}{\omega \, e}$$

d'où
$Te(-k1(\alpha) + k3(\alpha) + 2k4(\alpha)) = $

$$\frac{\alpha}{\omega \, e} = \frac{\alpha}{2\pi \times \frac{1}{4}Te} = \frac{2\alpha Te}{\pi}$$

Cette dernière relation donne une quatrième équation qui est égale à

$$-k1(\alpha) + k3(\alpha) + 2k4(\alpha) = \frac{2}{\pi} \qquad (15)$$

Les équations (11), (12), (14) et (15) forment un système de quatre équations avec quatre inconnues k(i) qui permet de calculer les coefficients k(i) .
La résolution de ce système d'équations permet d'écrire

$$k1(\alpha) = \frac{1}{2}(1 - \frac{2\alpha}{\pi} - \cos\alpha) \qquad (16)$$

$$k2(\alpha) = \cos\alpha + \frac{1}{2}(\frac{2\alpha}{\pi} - \sin\alpha) \qquad (17)$$

$$k3(\alpha) = \frac{1}{2}(1 - \frac{2\alpha}{\pi} - \cos\alpha + 2\sin\alpha) \qquad (18)$$

$$k4(\alpha) = \frac{1}{2}(\frac{2\alpha}{\pi} - \sin\alpha) \qquad (19)$$

avec $\alpha$ variant de 0 à

EP 0 205 373 B1

$$\frac{\pi}{2}$$

pour un retard situé entre 0 et Te .

La figure 17 représente la réponse impulsionnelle (B) du filtre obtenu par les coefficients k(i)(α). Cette réponse impulsionnelle est comparée à une réponse impulsionnelle (A) théorique du filtre gabarit représenté à la figure 3 de réponse impulsionnele égale à

$$\frac{\sin 2\alpha}{2\alpha} \cdot$$

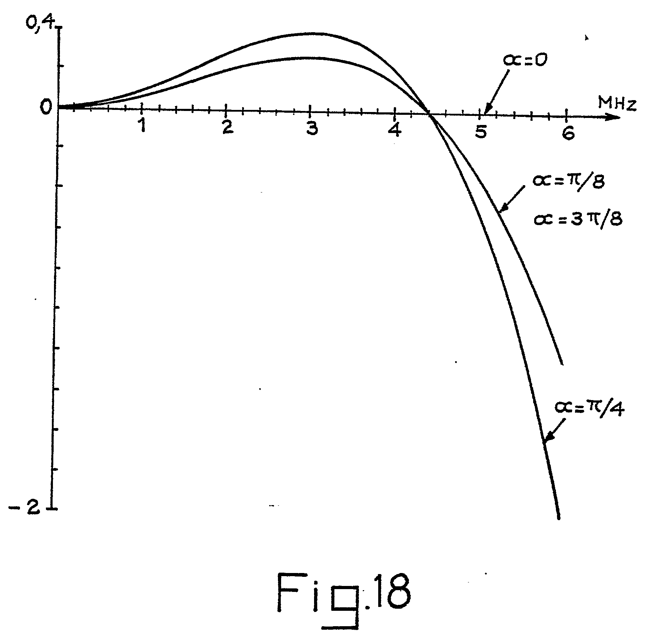

L'échantillonnage de cette réponse impulsionnelle aux valeursα donne les coefficients k(i)(α) du correcteur de phase. La connaissance des coefficients k(i)(α) permet de calculer, le module M(ω,α) représenté à la figure 18 et la phase $\phi$ (ω,α). De cette phase $\phi$(ω,α) on en déduit l'erreur de temps de propagation par rapport à la consigne

$$\tau (\alpha) = \frac{\alpha}{\omega e}$$

(figure 19).

L'erreur de temps de propagation vérifie les relations

$\varepsilon(\omega,\alpha) = \tau'(\omega,\alpha) - \tau(\omega e,\alpha) \ \ ... \ (20)$

soit encore

$$\varepsilon(\omega ,\alpha) = -\frac{1}{\omega}\times \phi (\omega ,\alpha) - \frac{\alpha}{\omega e} \qquad (21)$$

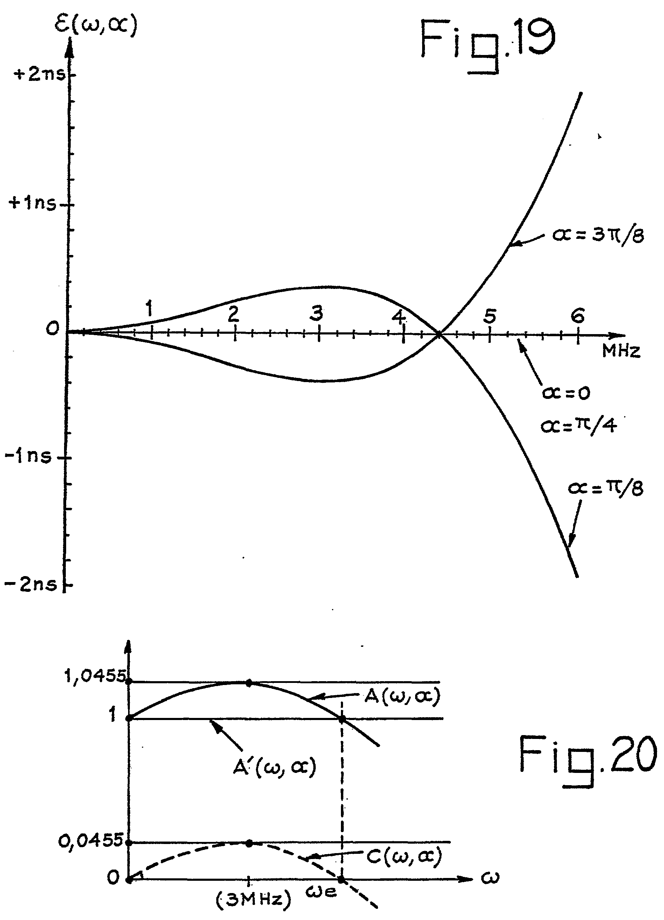

Dans l'exemple de la figure 19 la bande passante utile est comprise entre 0 et 5,5 MHz et l'erreur de temps de propagation $\varepsilon(\omega,\alpha)$ est totalement négligeable et inférieure à 0,4 ns. Pour les fréquences situées autour de 3,5 MHz, le module M(ω,α), figure 18, a une variation, fonction de α , de 0 à 0,4 db soit un gain qui varie de 1 à 1,0455. L'allure de cette variation est de la forme A × sin 2α avec A = 1,0455, le maximum étant défini pour

$$\alpha = \frac{\pi}{4} \cdot$$

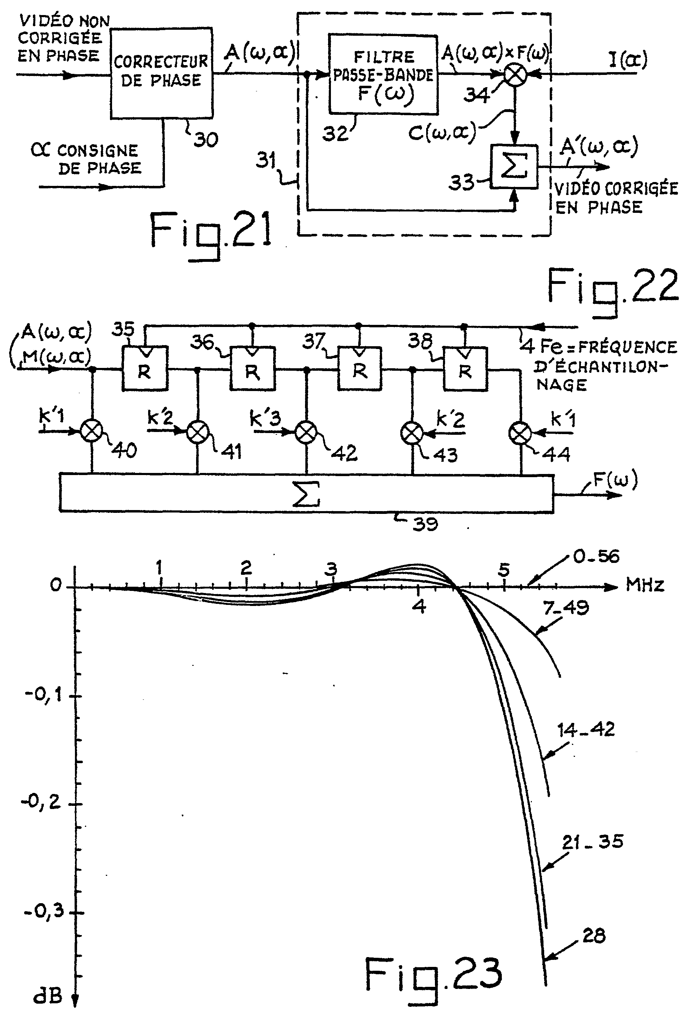

Cette variation de gain entraine du bruit d'amplitude non négligeable, d'environ 4,5 % . La connaissance du module M(ω,α) permet de déduire, figure 18, la variation de gain Δ A (α) = 1,0455 × sin 2α du correcteur de phase pour F peu différent de 3 MHz. L'exemple de réalisation montré à la figure 21 permet de minimiser la variation de gain à la sortie du correcteur de phase. Le dispositif représenté comprend le correcteur de phase 30 de quatre coefficients du type de celui qui vient d'être décrit et un correcteur de gain 31 constitué par un filtre passe-bande 32, un circuit sommateur 33 et un circuit multiplieur 34. Son rôle est de soustraire au gain A(ω,α) en sortie du correcteur de vélocité une valeur C(ω,α) afin d'obtenir un gain A'(ω,α) après correction d'amplitude presque unitaire quel que soit ω et α ceci en conservant la phase du correcteur de vélocité à un retard près constant. Le filtre passe-bande 32 à phase linéaire (retard constant) fournit une variation de gain F(ω). Le filtre 32 est déterminé pour avoir un gain nul pour ω = 0 et ω=ω e et passer par un maximum vers 3 MHz. F(ω) doit naturellement être multiplié par une constante de proportionnalité I(α) fonction de α. Dans ces conditions la valeur C(ω,α) vérifie la relation

$C(\omega,\alpha) = A(\omega,\alpha) \times F(\omega) \times I(\alpha) \ \ ... \ (22)$

Une réalisation du filtre passe-bande 32 est représentée à la figure 22, celle-ci est constituée par un filtre transversal non récursif classique à cinq coefficients symétriques par rapport au coefficient central. Le filtre représenté comprend quatre registres 35 à 38 reliés en série et couplés à un sommateur 39 au travers de cinq multiplieurs 40 à 44. En conférant au filtre de la figure 22 un retard constant égal à deux périodes d'échantillonnage on obtient les relations suivantes

$2k'1 \times \cos(2\omega Te) + 2k'2 \times \cos(\omega Te)+k'3 = F(\omega) \ \ ... \ (23)$

et pour $\omega= 0, F(\omega) = 0 = 2k'1 + 2k'2 + k'3 \ \ ... \ (24)$

9

et pour $\omega = \omega e, F(\omega) = 0 = - 2k'1 + k'3 \ldots$ (25)

En choisissant k'3 = -1 pour obtenir la même phase qu'au point milieu du filtre on obtient

k'1 = - 0,5, k'2 = 1, k'3 = - 1 ... (26)

d'où $F(\omega) = - \cos( 2 \omega Te) + 2\cos (\omega Te) - 1 \ldots$ (27)

$F(\omega)$ est maximale lorsque sa dérivée $F'(\omega)$ par rapport à $\omega$ est nulle soit encore lorsque $F'(\omega) = 2Te \times \sin (2 \omega Te) - 2Te \times \sin (\omega Te) = 0$ ou encore $F'(\omega) = \sin (2 \omega Te) - \sin (\omega Te) = 0$ et en développant $\sin (2 \omega Te)$ on obtient $2 \sin (\omega Te) \times \cos (\omega Te) = \sin (\omega Te)$

d'où $\cos (\omega Te) = 0,5$ soit encore

$$\omega Te = \frac{\pi}{3} \text{ et } \omega = \frac{\pi}{3Te} = 2 \pi F$$

Par conséquent $F(\omega)$ est maximale pour F = 1/6Te = 3 MHz.

Le gain maximal de $F(\omega)$ pour F = 3 MHz est alors F maxi = - cos

$$\frac{2\pi}{3} + 2 \cos \frac{\pi}{3} - 1 = 0,5$$

Le coefficient $I(\alpha)$ vérifie les relations suivantes

$$A(3 \text{ MHz},\frac{\pi}{4}) = 1,0455 \longleftrightarrow A(3\text{MHz}, \frac{\pi}{4}) \times F(3\text{MHZ}) = 1,0455 \times 0,5 =$$

soit

$$A'(3\text{MHz}, \frac{\pi}{4}) = A(3\text{MHz}, \frac{\pi}{4}) + A(3\text{MHz}, \frac{\pi}{4}) \times F(3\text{MHz}) \times I(\frac{\pi}{4})$$

soit encore

$$A' = 1 = 1,0455 + (0,5 \times 1,0455) \times I(\frac{\pi}{4})$$

Par conséquent

$$I(\frac{\pi}{4}) = \frac{1 - 1,0455}{0,5 \times 1,0455} = - 0,087$$

et la fonction $I(\alpha)$ devient alors $I(\alpha) = -0,087 \times \sin 2\alpha \ldots$ (28)

Cette fonction peut être obtenue par mémorisation des valeurs $I(\alpha)$ dans une mémoire PROM qui reçoit la valeur $\alpha$ comme consigne. Le module obtenu après correction d'amplitude est représenté à la figure 23 et $\varepsilon(\omega,\alpha)$ reste inchangée et est toujours celle qui est représentée à la figure 19.

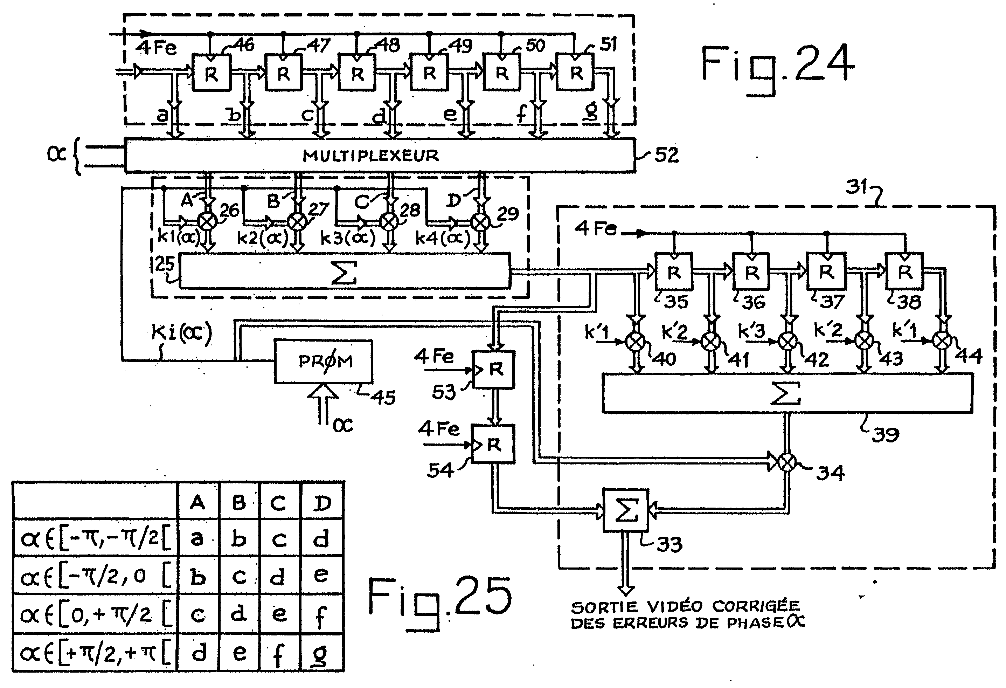

L'assemblage du filtre correcteur de phase de la figure 14A au correcteur de gain 31 de la figure 21 pour constituer le correcteur de vélocité de l'invention en accord avec le schéma de principe de la figure 21 est représenté à la figure 24. Comme sur la figure 14A le correcteur de phase de la figure 24 est constitué de quatre multiplieurs 26 à 29 et du sommateur 25. Le correcteur de gain est constitué, comme sur les figures 21 et 22, du filtre transversal non récursif 32 formé des éléments 35 à 44 précédemment décrits du sommateur 33 et du multiplieur 34. La sortie du sommateur 25 est reliée à l'entrée du correcteur de gain 31 constituée par l'entrée du registre 35 et une entrée d'opérande du multiplieur 40. Une mémoire programmable PROM 45 contient en mémoire les coefficients k(i)(α) et I(α) précédemment définis par les relations (16), (17), (18) et (19). Ces coefficients sont adressés par le décalage de phase α . Les coefficients K(i)(α) sont appliqués sur des premières entrées d'opérandes des multiplieurs 26 à 29 et le coefficient I(α) est appliqué sur une première entrée d'opérande du multiplieur 34. Les deuxièmes entrées d'opérande des multiplieurs 26 à 29 sont reliées aux sorties de registres à décalage 46 à 51 montés en série au travers d'un multiplexeur 52 qui réalise le branchement des deuxièmes entrées d'opérandes des multiplieurs 26 à 29 aux six sorties (b, c, d, e, f, g) des registres 46 à 51 et à l'entrée du registre 46 en fonction du décalage de phase α suivant le diagramme d'état représenté à la figure 25. Le retard apporté par le correcteur de gain 31 est compensé par deux registres 53 et 54 interposés en série entre la sortie du correcteur de phase et une entrée d'opérande du sommateur 33, l'autre entrée d'opérande étant reliée à la sortie du multiplieur 34.

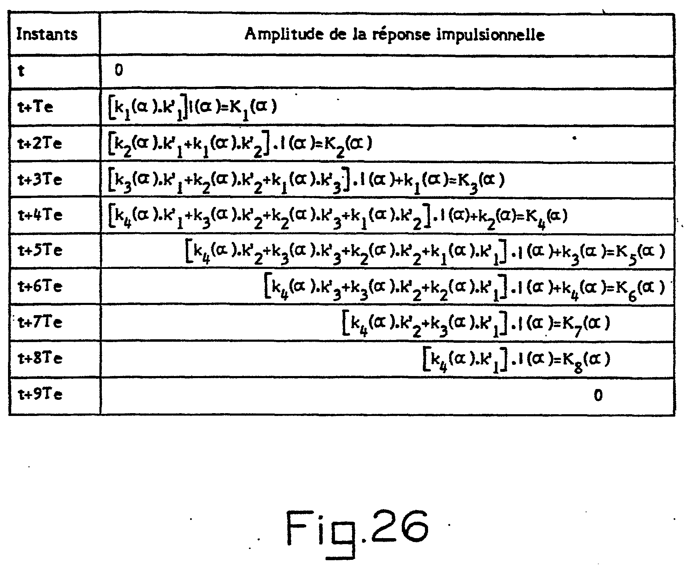

Le correcteur de vélocité qui est ainsi obtenu est réalisé avec seulement cinq multiplieurs qui réalisent la multiplication par les coefficients k(i)(α) et l(α). Comme les coefficients k'(i) du filtre passe-bande du correcteur d'amplitude ont des valeurs fixes ceux-ci sont réalisés simplement par cablage. La réponse impulsionnelle de l'ensemble est représentée par le tableau de la figure 26 qui simule la circulation de l'impulsion unitaire de durée Te à l'intérieur du correcteur de vélocité.

Dans ce tableau les valeurs k'1, k'2 et k'3 ont respectivement pour valeurs k'1 = - 0,5, k'2 = 1 èt k'3 = -1 et sont par conséquent indépendantes de α.

Les huit termes K(i)(α) obtenus représentent les échantillons de la réponse impulsionnelle aux instants t + iTe.

Il résulte de ce qui précède que le correcteur de vélocité selon l'invention pourrait également être obtenu à l'aide d'un seul filtre à huit coefficients K(i)(α). Toutefois cette réalisation nécessiterait huit multiplieurs au lieu de 5 et une capacité de mémoire PROM beaucoup plus importante ce qui rendrait cette solution plus coûteuse.

On notera également que dans certaines variantes de réalisation consistant par exemple à corriger n'importe quelle erreur de phase à l'intérieur d'une période d'échantillonnage, le schéma de réalisation de la figure 26 peut être simplifié en supprimant le multiplexeur 52 et en reliant directement les deuxièmes entrées d'opérandes A, B, C, D des multiplieurs 26 à 29 directement respectivement pour les entrées B, C, D aux sorties de trois registres montés en série et pour l'entrée A à l'entrée du premier registre recevant les échantillons du signal vidéo.

Egalement on pourra noter que l'invention n'est pas limitée à l'utilisation d'un filtre à cinq coefficients pour réaliser le correcteur d'amplitude, un filtre d'ordre impair quelconque pourra également être employé et dans ce cas on veillera à apporter au retard sur le trajet non corrigé en amplitude un retard égal au retard du filtre passe-bande.

## Revendications

1. Déphaseur variable numérique caractérisé en ce qu'il comprend un correcteur de phase (30) à temps de propagation variable constitué par un filtre numérique transversal non récursif (22, ... , 29), ayant un nombre N déterminé pair de coefficients, couplé à un correcteur d'amplitude (31) pour corriger les variations de gain du correcteur de phase de manière à obtenir un gain global du déphaseur variable numérique à peu près constant.

2. Déphaseur variable numérique selon la revendication 1, caractérisé en ce que la correction d'amplitude comprend un filtre passe-bande (32), un circuit multiplieur (34) et un circuit sommateur (33) couplé par une première entrée à l'entrée du filtre passe-bande (32) et par une deuxième entrée à la sortie du circuit multiplieur (34), le circuit multiplieur (34) recevant sur une première entrée une indication de phase de consigne et étant couplé par une deuxième entrée à la sortie du filtre passe-bande (32).

3. Déphaseur selon la revendication 2, caractérisé en ce que le filtre passe-bande (32) est constitué par un filtre numérique transversal non récursif comprenant un nombre M déterminé impair de coefficients.

4. Déphaseur selon l'une quelconque des revendications 1 à 3, caractérisé en ce que le filtre numérique transversal non récursif constituant le correcteur de phase est un filtre à quatre coefficients $k_1(\alpha)$, $k_2(\alpha)$, $k_3(\alpha)$ et $k_4(\alpha)$ dépendant de la valeur de la phase de consigne α liés par les relations

$$k_2(\alpha) - k_4(\alpha) = \cos(-\alpha)$$

$$k_1(\alpha) - k_3(\alpha) = \sin(-\alpha)$$

$$k_1(\alpha) + k_2(\alpha) + k_3(\alpha) + k_4(\alpha) = 1$$

$$-k_1(\alpha) + K_3(\alpha) + 2K_4(\alpha)$$

$$= \frac{2\alpha}{\pi}$$

et échantillonné à une fréquence égale à 4 fois la fréquence de récurrence du signal à déphaser.

5. Déphaseur selon l'une quelconque des revendications 2 à 4, caractérisé en ce que le filtre passe-bande (32) est un filtre numérique transversal non récursif à 5 coefficients ayant respectivement pour valeurs - 0,5, 1, -1, 1 et - 0,5.

6. Déphaseur selon l'une quelconque des revendications 4 et 5, caractérisé en ce que les valeurs

des quatre coefficients $k_1(\alpha)$, $k_2(\alpha)$, $k_3(\alpha)$ et $k_4(\alpha)$ sont contenues mémorisées à l'intérieur d'une mémoire morte programmable (45) adressée par la valeur de phase de consigne $\alpha$.

7. Utilisation du déphaseur selon l'une quelconque des revendications 1 à 6 à la réalisation d'un correcteur de vélocité numérique pour magnétoscope.

### Claims

1. A variable digital phase shifter, characterized in that it comprises a variable propagation time phase corrector (30) constituted by a non-recursive transversal digital filter (22, ..., 29) having a fixed even number N of coefficients, connected to an amplitude corrector (31) for correcting the variations in gain of the phase corrector, such as to obtain a nearly constant global gain of the variable digital phase shifter.

2. A digital variable phase shifter according to claim 1, characterized in that the amplitude correction circuit comprises a pass-band filter (32), a multiplier circuit (34) and a summing circuit (33), connected by ma first input to the input of the pass-band filter (32) and by a second input to the output of the multiplier circuit (34), the multiplication circuit (34) receiving a set point phase indication at its first input and being connected by a second input to the output of the pass-band filter (32).

3. A phase shifter according to claim 2, characterized in that the pass-band filter (32) is constituted by a non-recursive, transversal digital filter comprising a fixed uneven number M of coefficients.

4. A phase shifter according to any one of the claims 1 to 3, characterized in that the non-recursive transversal digital filter, which constitutes the phase corrector, is a filter including four coefficients $k_1(\alpha)$, $k_2(\alpha)$, $k_3(\alpha)$ and $k_4(\alpha)$ depending upon the value of the set point phase $\alpha$, which coefficients are interrelated according to the following equations:

$$k_2(\alpha) - k_4(\alpha) = \cos(-\alpha)$$

$$k_1(\alpha) - k_3(\alpha) = \sin(-\alpha)$$

$$k_1(\alpha) + k_2(\alpha) + k_3(\alpha) + k_4(\alpha) = 1$$

$$-k_1(\alpha) + k_3(\alpha) + 2k_4(\alpha)$$

$$= \frac{2\alpha}{\pi}$$

and which is sampled at a frequency four times as high as the recurrence frequency of the signal to be phase shiftet.

5. A phase shifter according to any one of the claims 2 through 4, characterized in that the pass-band filter (32) is a non-recursive transversal digital filter including five coefficients, having respectively the values of $-0,5$, 1, $-1$, 1 and $-0,5$.

6. A phase shifter according to claim 4 or 5, characterized in that the values of the four coefficients $k_1(\alpha)$, $k_2(\alpha)$, $k_3(\alpha)$ and $k_4(\alpha)$ are stored in a programmable read-only memory (45), which is addressed by the set point phase value $\alpha$.

7. The use of the phase shifter according to any one of claims 1 through 6 in the implementation of a digital speed corrector for a video recorder.

### Patentansprüche

1. Digitaler veränderbarer Phasenschieber, dadurch gekennzeichnet, daß er einen Phasenentzerrer (30) mit veränderlicher Laufzeit besitzt, der aus einem nicht-rekursiven digitalen Transversalfilter (22, ..., 29) besteht, das eine festgesetzte gerade Anzahl N von Koeffizienten aufweist und an einen Amplitudenentzerrer (31) zur Korrektur der Verstärkungsschwankungen des Phasenentzerrers gekoppelt ist, derart, daß eine nahezu konstante globale Verstärkung des digitalen veränderbaren Phasenschiebers erzielt wird.

2. Digitaler veränderbarer Phasenschieber nach Anspruch 1, dadurch gekennzeichnet, daß die Amplitudenentzerrungsschaltung ein Bandpaßfilter (32), eine Multiplizierschaltung (34) und eine Summierschaltung (33) aufweist, die über einen ersten Eingang an den Eingang des Bandpaßfilters (32) und über einen zweiten Elngang an den Ausgang der Multiplizierschaltung (34) gekoppelt ist, wobei die Multiplizierschaltung (34) über einen ersten Eingang eine Angabe über die Sollphase zugeführt erhält und über einen zweiten Eingang an den Ausgang des Bandpaßfilters (32) angeschlossen ist.

3. Phasenschieber nach Anspruch 2, dadurch gekennzeichnet, daß das Bandpaßfilter (32) aus einem nicht-rekursiven digitalen Transversalfilter mit einer bestimmten ungeraden Anzahl M von Koeffizienten besteht.

4. Phasenschieber nach einem beliebigen der Ansprüche 1 bis 3, dadurch gekennzeichnet, daß das nicht-rekursive digitale, den Phasenentzerrer bildende Transversalfilter ein Filter mit vier Koeffizienten $k_1(\alpha)$, $k_2(\alpha)$, $k_3(\alpha)$ und $k_4(\alpha)$ ist, die von der Größe der Sollphase $\alpha$ abhängen und durch die folgenden Beziehungen miteinander verknüpft sind:

$$k_2(\alpha) - k_4(\alpha) = \cos(-\alpha)$$

$$k_1(\alpha) - k_3(\alpha) = \sin(-\alpha)$$

$$k_1(\alpha) + k_2(\alpha) + k_3(\alpha) + k_4(\alpha) = 1$$

$$-k_1(\alpha) + k_3(\alpha) + 2k_4(\alpha) = \frac{2\alpha}{\pi}$$

und die mit einer Frequenz abgetastet werden, welche der vierfachen Wiederholungsfrequenz des in der Phase zu verschiebenden Signals entspricht.

5. Phasenschieber nach einem beliebigen der Ansprüche 2 bis 4, dadurch gekennzeichnet, daß das Bandpaßfilter (32) ein nicht-rekursives digitales Transversalfilter mit fünf Koeffizienten ist, welche jeweils die Werte −0,5, 1, −1, 1 und −0,5 besitzen.

6. Phasenschieber nach Anspruch 4 oder 5, dadurch gekennzeichnet, daß die Werte der vier Koeffizienten $k_1(\alpha)$, $k_2(\alpha)$, $k_3(\alpha)$ und $k_4(\alpha)$ in einem programmierbaren Festspeicher (45) gespeichert sind, der vom Phasensollwert $\alpha$ adressiert wird.

7. Verwendung des Phasenschiebers nach einem beliebigen der Ansprüche 1 bis 6 zur Herstellung eines digitalen Geschwindigkeitskorrekturglieds für einen Videorecorder.

Fig.1

Fig.2

Fig.3

Fig.4

Fig.5

Fig.6

Fig.7

Fig.8

Fig.9

Fig.10

$f(t)=\delta(t)\Rightarrow F(\omega)=S(\omega)$

```
         ┌──────┐    f'(t)              ┌──────────┐   f'(t-τ(∝)
 ────────│ T(ω) │─────────────────────│ e⁻ʲωτ(∝) │────────────────
         └──────┘   S(ω)xT(ω)⇒R(t)     └──────────┘  R'(t)=R(t-τ(∝))
           1A                              │            1B
                          ∝ ───────────────┘
```

## Fig.11

## Fig.12

## Fig.13

Fig.14A

Fig.14B

Fig.14C

Fig.14D

Fig.15

Fig.16

Fig.17

Fig.18

Fig.19

Fig.20

VIDÉO NON
CORRIGÉE
EN PHASE

CORRECTEUR
DE PHASE

$A(\omega,\alpha)$

FILTRE
PASSE-BANDE
$F(\omega)$

$A(\omega,\alpha) \times F(\omega)$

$I(\alpha)$

34

$C(\omega,\alpha)$

32

31

30

$\propto$ CONSIGNE
DE PHASE

33

$\sum$

$A'(\omega,\alpha)$

VIDÉO CORRIGÉE
EN PHASE

## Fig.21

## Fig.22

$A(\omega,\alpha)$
$M(\omega,\alpha)$

35

R

36

R

37

R

38

R

4 Fe = FRÉQUENCE
D'ÉCHANTILLON-
NAGE

k'1

40

k'2

41

k'3

42

k'2

43

k'1

44

$\sum$

$F(\omega)$

39

0

1

2

3

4

5

0-56

MHz

7-49

-0,1

14-42

-0,2

21-35

-0,3

28

dB

## Fig.23

Fig.24

Fig.25

SORTIE VIDÉO CORRIGÉE
DES ERREURS DE PHASE $\alpha$

| | A | B | C | D |
|---|---|---|---|---|
| $\alpha \in [-\pi, -\pi/2[$ | a | b | c | d |
| $\alpha \in [-\pi/2, 0[$ | b | c | d | e |
| $\alpha \in [0, +\pi/2[$ | c | d | e | f |
| $\alpha \in [+\pi/2, +\pi[$ | d | e | f | g |

EP 0 205 373 B1

| Instants | Amplitude de la réponse impulsionnelle |
|---|---|
| t | 0 |
| t+Te | $\left[k_1(\alpha).k'_1\right]I(\alpha){=}K_1(\alpha)$ |
| t+2Te | $\left[k_2(\alpha).k'_1{+}k_1(\alpha).k'_2\right].I(\alpha){=}K_2(\alpha)$ |
| t+3Te | $\left[k_3(\alpha).k'_1{+}k_2(\alpha).k'_2{+}k_1(\alpha).k'_3\right].I(\alpha){+}k_1(\alpha){=}K_3(\alpha)$ |
| t+4Te | $\left[k_4(\alpha).k'_1{+}k_3(\alpha).k'_2{+}k_2(\alpha).k'_3{+}k_1(\alpha).k'_2\right].I(\alpha){+}k_2(\alpha){=}K_4(\alpha)$ |
| t+5Te | $\left[k_4(\alpha).k'_2{+}k_3(\alpha).k'_3{+}k_2(\alpha).k'_2{+}k_1(\alpha).k'_1\right].I(\alpha){+}k_3(\alpha){=}K_5(\alpha)$ |
| t+6Te | $\left[k_4(\alpha).k'_3{+}k_3(\alpha).k'_2{+}k_2(\alpha).k'_1\right].I(\alpha){+}k_4(\alpha){=}K_6(\alpha)$ |
| t+7Te | $\left[k_4(\alpha).k'_2{+}k_3(\alpha).k'_1\right].I(\alpha){=}K_7(\alpha)$ |
| t+8Te | $\left[k_4(\alpha).k'_1\right].I(\alpha){=}K_8(\alpha)$ |
| t+9Te | 0 |

# Fig.26